# EUROPEAN PATENT SPECIFICATION

(11) **EP 0 404 277 B1**
(45) Date of publication and mention of the grant of the patent: **28.09.1994**
(21) Application number: 90202185.6
(22) Date of filing: 06.02.1985
(51) Int. Cl.: H01R 43/20, H05K 7/10

(54) **Method of inserting a chip carrier contact into a housing**
Verfahren, um einen Schaltungsträgerkontakt in ein Gehäuse einzusetzen
Méthode d'insertion d'un contact de support de puce dans un boîtier

(30) Priority: 27.02.1984 US 584274
(43) Date of publication of application: 27.12.1990
(62) Divisional of application: 85300782.1
(73) Proprietor: THE WHITAKER CORPORATION, Wilmington, Delaware 19808 (US)
(72) Inventor: Grabbe, Dimitry, Middletown, Pennsylvania 17057 (US); Korsunsky, Iosif, Harrisburg, Pennsylvania 17110 (US)
(74) Representative: Warren, Keith Stanley

(56) References cited:
- DE-C- 950 221
- FR-A- 2 365 899
- FR-A- 2 427 761
- US-A- 3 753 211
- US-A- 3 910 664

## Description

This invention relates generally to contacts for use with chip carriers and, more particularly, to a method for inserting a chip carrier contact into a housing.

With the frequency of chip carrier utilization being on the rise in conjunction with ever-decreasing prices, the use of socket housings to receive the chip carriers has and will continue to take on the same usage and pricing characteristics. However, this results in an increasing demand for less costly material as well as minimizing the amount of material. Further, contact and housing configurations are varied so as to maximize contact mating forces and contribute to ease of manufacturing. Such types of devices may be found, for example, in US-A-4,089,575; US-A-3,910,664 and US-A-3,753,211.

However, a continuing problem with contact arrangements for chip carrier sockets is that, due to inherently small contact size, handling and therefore insertion into the housings is quite problematic, requiring a reasonably high degree of precision and is generally time-consuming. This is aggravated by the fact that during contact insertion should any contacts become slightly bent or misaligned, contact mating forces may fall below generally acceptable limits. It is generally for this reason, as well as the presence of marginal contact mating forces inherent in small contacts, that gold plating is utilized.

Accordingly, it is desirable to employ a method which does not require the handling of small individual parts during insertion into a housing. It is also desirable to have a contact arrangement which facilitates rapid insertion into its associated housing.

The present invention consists in a method for inserting a chip carrier contact into a housing, comprising the steps of: (a) positioning a carrier strip having contacts and an indexing notch formed unitarily with the carrier strip, adjacent to a chip carrier housing and a feeder/cutter; (b) continuously rotating the feeder/cutter so that a spirally disposed feeder ring engages the indexing notch thereby urging the contact into slots contained in the housing while a cam-like cutter ring severs the contact which is being inserted, from the carrier strip as well as a portion of the carrier strip between the contact and the next contact to be inserted into the housing; (c) indexing the housing so that said next contact to be inserted therein is adjacent an empty slot in said housing; and (d) repeating the steps (b) and (c).

There is disclosed in FR-A-2 427 761, a machine for inserting electronic components into printed circuit boards. The components are initially connected together by a carrier web. The machine separates the components and passes the separated components to chucks on a rotary disc where excess leads of the component are cut off. The separated components are then transferred to a device for inserting them into the printed circuit board.

An embodiment of the present invention will now be described by way of example with reference to the accompanying drawings in which:
Figure 1 is an exploded isometric view of a chip carrier, a socket housing and a circuit board, the socket housing having been produced using the method according to an embodiment of the invention;
Figure 2 is a cross-sectional view of the assembled structure of Figure 1 with the chip carrier about to be inserted into the socket housing;
Figure 3 is a cross-sectional view similar to that of Figure 2 with the chip carrier inserted into the socket housing;
Figure 4 is an isometric view of the assembled structure shown in Figure 1;
Figure 5 is an isometric view of the underside of the housing with the contacts about to be inserted therein;
Figure 6 is a view similar to that of Figure 5 showing the contacts about to be separated from their carrier strip; and
Figure 7 is a view similar to that of Figure 6 showing more detail of the feed and cutting mechanism utilized for the insertion of the contacts into the housing in accordance with said embodiment of the invention.

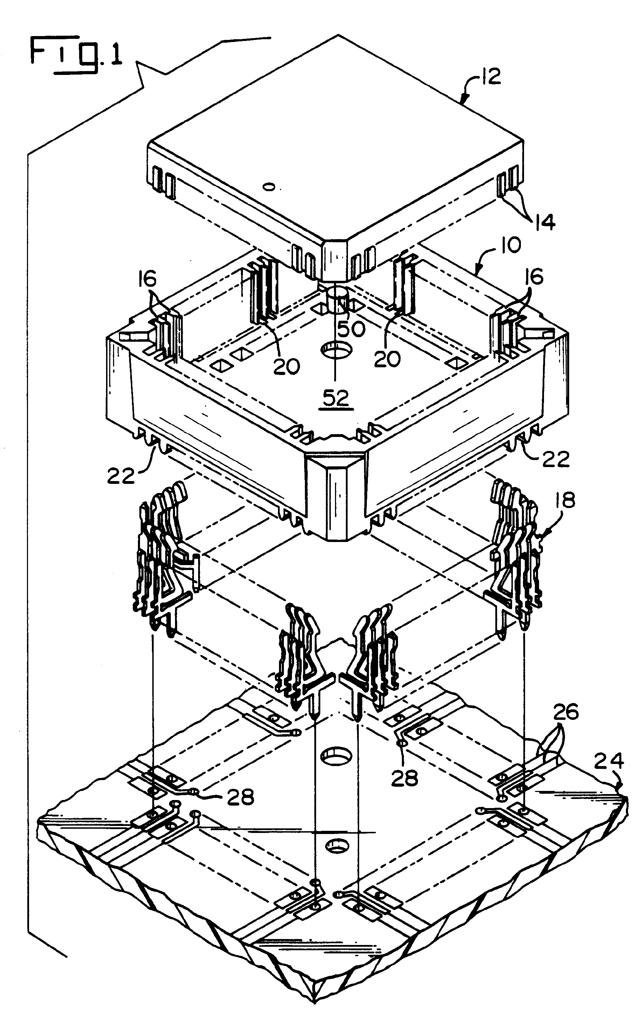

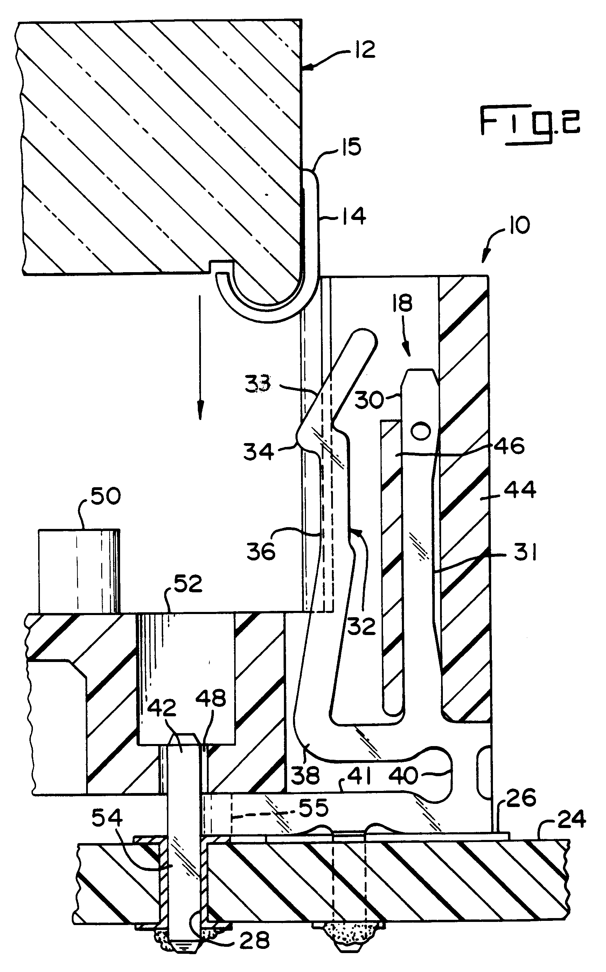

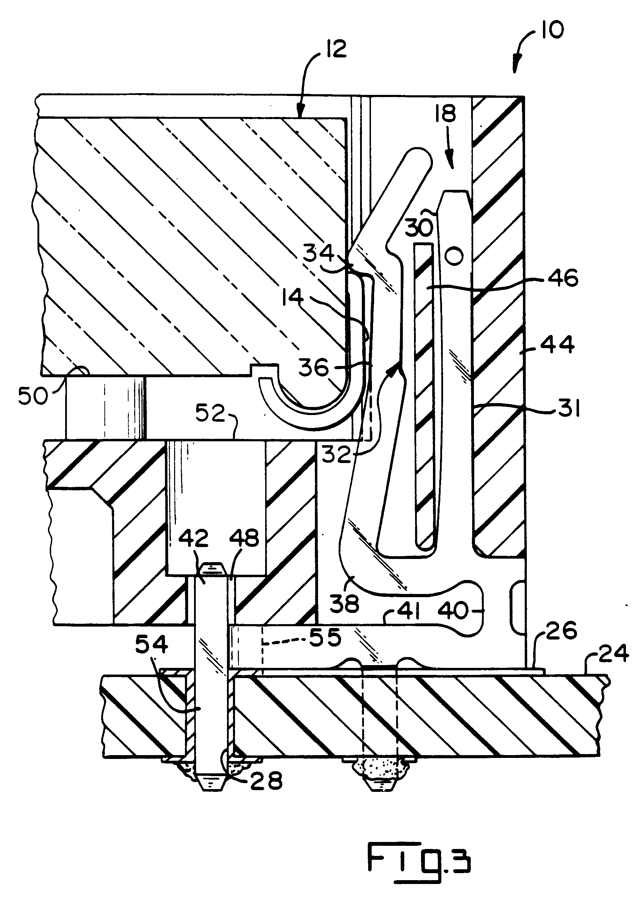

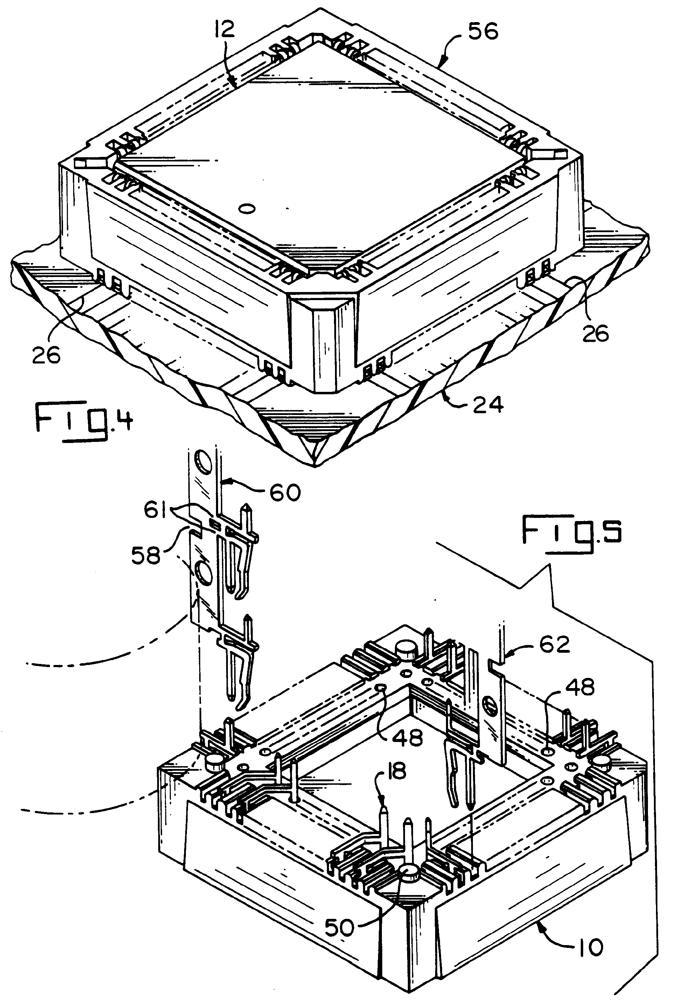

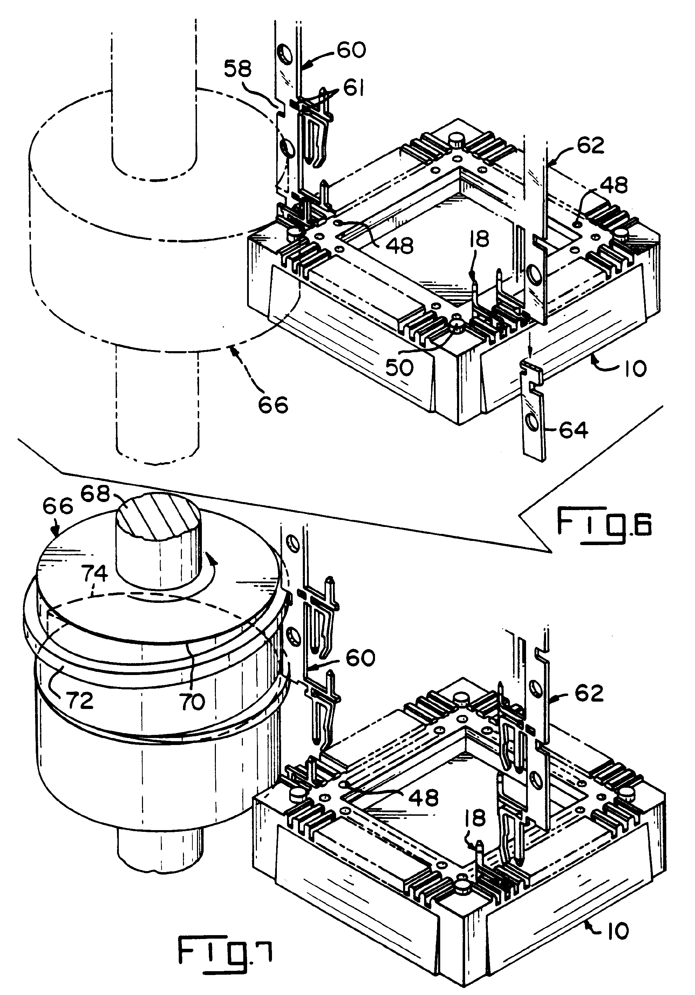

Referring to Figure 1 of the drawings, a contact chip carrier socket housing is shown generally at 10 with a chip carrier 12 shown above the housing 10 which, preferably, is a molded plastic part. The chip carrier 12 has conductive pads or leads 14 thereon and, preferably, the chip carrier 12 is a post molded chip carrier although other types of chip carriers can and may be used.

The housing 10 has contact spacing barriers 16 disposed in the interior which are utilized to separate chip carrier contacts shown generally at 18. The housing 10 has front beam apertures 20 disposed adjacent the spacing barriers 16 and contact lower arm barriers 22 disposed on the underside of the housing 10 which, similar to the spacing barriers 16, provide electrical and physical isolation between adjacent contacts 18. The housing 10 is to be disposed on a circuit board shown generally at 24 with the circuit board having conductive strips 26 thereon and plated holes 28 disposed therein. It is to be understood that, although in the preferred embodiment of the present invention the circuit board 24 is a printed circuit board having plated through holes, other types of circuit boards such as silk-screened can and may be utilized without departing from the scope of the present invention while plated through holes need not be utilized at all.

Referring now to Figure 2, a cross-sectional view of the assembled structure may be seen. The chip carrier 12 as mentioned has conductive pads 14 thereon which are arcuately bent from the side of the chip carrier to the underside thereby forming a conductive pad retention portion 15 at the point where the conductive pad 14 exits the chip carrier 12. The contact housing 10 is comprised of a housing exterior wall 44 and a housing intermediate wall 46 with a chip carrier stop 50 disposed on the housing inner floor 52. The chip carrier contact forms a generally tuning fork type of arrangement having a contact rear arm 30 which has a rear beam flexing portion 31 and a contact front beam 32 having a front beam upper portion 33, a front beam retention portion 34, and a front beam lower portion 36. A front beam pivot elbow 38 provides pivoting motion for the entire contact front beam 32. A contact pivot arm 40 is disposed at the bottom of the tuning fork arrangement for providing isolation between the tuning fork portion and the bottom portion of the contact in order not to transfer a load to the circuit board solder which is particularly important when the present device is surface mounted and is adjacent an interconnection area shown generally at 41 which is utilized for interconnecting the contact 18 to the conductive strip 26. The contact 18 in one arrangement (as shown more fully in Figures 5, 6 and 7) has a contact locating pin 42 which mates with the locating pin aperture 48 disposed in the housing 10. A contact pin 54 is opposite the contact locating pin 42 and is used for mating with a plated through hole disposed in the circuit board 24. As mentioned, since plated through holes may be eliminated, the interconnection area shown generally at 41 may be cut at a surface mount point in the area of 55 which may but does not have to necessitate the removal of contact locating pins such as 42 and contact pins such as 54. In this manner, surface mounting to the circuit board 24 directly to the conductive strips 26 may be utilized.

Referring now to Figure 3, there is shown a cross-sectional view of the housing 10 mated with a chip carrier. Here it can be readily seen that, upon insertion of the chip carrier 12 into the housing 10 the conductive pad 14 is in a wiping motion mated with the front beam retention portion 34 contained on the contact 18. This thereby removes any oxides or foreign matter which may be present on contacting surfaces. Readily seen is how the conductive pad retention portion 15 engages and slightly pushes up against the front beam retention portion thereby maintaining the chip carrier 12 fixedly in the housing 10. Also, upon insertion of the carrier 12 into the housing 10 the entire contact front beam 32 is caused to move, pivoting about the front beam elbow portion 38 while the contact rear beam 30 is deformed slightly such that the rear beam flexing portion 31 moves and more fully impinge upon the inner surface of the housing exterior wall 44 which in an exaggerated fashion is shown almost completely straightened out. This thereby helps to create and maintain extremely high forces of a contact mating nature between the conductive pads and the contact 18. Therefore, in the preferred embodiment of the present invention, the contacts 18 and the carrier strip associated with them (not shown) are stamped from beryllium copper. In this manner, electrical current may flow through the conductive pad retention portion 15 into the front beam retention portion 34 and thereafter through the front beam lower portion 36 into the lower portions of the contact to the conductive strips 26. This therefore creates an extremely short path so as to minimize any possible capacitive, inductive or resistive effects in the contact's usage.

Referring now to Figure 4, there is shown an assembled and fully mated contact and housing with the chip carrier. Here it can be seen that the chip carrier 12 does not have any type of hold-down bracket which might be used to maintain the chip carrier 12 in the housing 10. Also, the assembled and mated chip carrier and socket 56 does provide access at the top of the housing at the contact spacing barriers for a test probe to perform various testing functions while the chip carrier 12 is in a mated condition while individual contacts may be replaced without disassembly of all the contacts.

Referring now to Figure 5, there is shown the underside of the chip carrier just prior to contact insertion. Here it is readily obvious that two types of carrier strips are utilized for insertion of the contacts. A flat contact carrier strip 60 is placed in alternating sequence with the bent or offset contact carrier strip 62. It has been found that the use of these two types of carrier strips allows a staggering effect between adjacent contact pins 54 thereby allowing the pitch or center-to-center spacing to be constructed for high density situations. More precisely, the interconnection area 41 is bent on the bent contact carrier strip 62 while the interconnection area 41 is not bent on the flat contact carrier strip 60. Further, opposite the contact pin 54 is a contact locating pin 42 contained only on the bent contact carrier strip 62. The contact locating pin, as mentioned earlier, is placed into the locating pin aperture 48 disposed and shown on the underside of the housing 10. It has been found that the locating pin and aperture 42, 48 help ensure proper contact pin 54 alignment since the interconnection area 41 for the bent contact carrier strip 62 is longer than the interconnection area 41 contained on the flat contact carrier strip 60. The contacts 18, however, are of the same configuration regardless of the carrier strip with which they are utilized. The carrier strips 60, 62 have an indexing notch 58 regularly spaced along the edge which facilitates manufacture as well as insertion into the housing as will be described below with the contact 18 proper being attached to the carrier strips proper by arms 61. To facilitate insertion of the contacts 18 into the housing 12, the contacts 18 are inserted into the housing from the underside thereof. A feeder/cutter shown generally at 66 is utilized to partially insert the contacts into the housing 12. In the preferred embodiment of the present invention, this is accomplished through the use of two feeder/cutters with one inserting a flat contact carrier strip 60 on the one side of the housing and another inserting a bent contact carrier strip 62 on the opposing of the housing 12. It is to be understood, however, that less than or more than this number of feeder/cutters may be utilized without departing from the scope of the present invention.

Referring now to Figure 6, there is shown the next step for insertion of the contacts 18 into the housing 12. After partial insertion of the contact 18 into the housing 12, the feeder/cutter 66 through rotational movement translates the carrier strips 60, 62 towards the housing. Simultaneously the feeder/cutter 66 removes a portion of the carrier strip proper thereby leaving a discarded carrier strip piece such as shown at 64 (shown in more detail in Figure 7). Therefore, the contact 18 located close to the housing is almost completely seated into the housing 12 while the adjacent portion of the carrier strip proper is utilized to urge the contact 18 into the housing before itself being cut, with the process then being repeated. After insertion of the contact 18 into the appropriate slot, the housing is then indexed so that, by the time one side of the housing has been inserted in this manner, either a flat or bent contact carrier strip 60, 62 is deposited in every other slot in the housing. At this point the housing in the preferred embodiment of the present invention is rotated 90 degrees so that the adjacent sides are similarly inserted with contacts. After the adjacent sides are similarly inserted, the housing 12 is then rotated once again such that contacts to be inserted are presented to one side already having either flat or bent contact carrier strips 60, 62 deposited with a bent or flat contact carrier strip 62, 60 respectively now ready for insertion into alternating empty slots. Once this side is done, the housing is then rotated once more with the remainder of the contacts being inserted. In this manner, two sets of contacts on opposing sides of the housing are being inserted at all times in a continuous manner.

Referring now to Figure 7, there is shown in greater detail the insertion of contacts into the housing as well as severing of contacts from the carrier strip proper. Shown is the feeder/cutter which is comprised of a mandrel 70 having a center shaft portion 68 with a feeder 72 and a punch or cutter 74 circuitously disposed therearound. The feeder 72 engages the indexing notch 58 contained on the carrier strip and through rotation of the feeder/cutter 66 a contact 18 is inserted into the appropriate slot. Thereafter, through continued rotation of the feeder/cutter 66, the punch or cutter 74 is presented to the carrier strip and, due to the cam-like configuration of the punch or cutter, begins to and finally cuts through the carrier strip. Therefore, during each cycle of the punch or cutter 74, the lower arm of the two arms 61 adjacent the indexing notch 58 is. severed with the carrier strip also being cut and the upper arm of the two arms 61 associated with an adjacent contact 18 also being severed. In this manner by adjustment of the rotational speed of the feeder/cutter 66 in conjunction with the indexing done to the housing 10, contacts 18 are inserted in a continuous manner but at no time is a contact 18 handled as an individual piece until after inserted into the housing 10. Upon insertion of all contacts into the housing 10 the contacts 18 are given one last push so as to be fully seated into the housing 10 through the use of an anvil-like operation (not shown) but which is readily known and available to one skilled in the art.

It is to be remembered that many variations of the present invention may be utilized without departing from the scope of the claims. Such variations may include other types of contact materials such as steel and other types of plated metal such as nickel. Further, the inner or outer beams contained on the contact may be of a slightly different configuration so as to accommodate variations of conductive pads from chip carrier to chip carrier and/or may accommodate different types of housings which may utilize different spacing barriers or means. Also, the housing may be shaped in a rectangular configuration.

Therefore, in addition to the above-enumerated advantages, the disclosed embodiment produces a contact arrangement for chip carriers as well as a method for inserting them which is relatively inexpensive to utilize as well as manufacture and which eliminates the need for high precision associated with the handling and insertion of individual contacts. Further, the contacts allow for the elimination of gold on contact mating surfaces as well as the elimination of hold-down brackets or covers.

## Claims

1. A method for inserting a chip carrier contact (18) into a housing (10), comprising the steps of:
(a) positioning a carrier strip (60) having contacts (18) and an indexing notch (58) formed unitarily with the carrier strip (60), adjacent to a chip carrier housing and a feeder/cutter (66);
(b) continuously rotating the feeder/cutter (66) so that a spirally disposed feeder ring (72) engages the indexing notch (58) thereby urging the contact (18) into slots contained in the housing (10) while a cam-like cutter ring (74) severs the contact (18) which is being inserted, from the carrier strip (60) as well as a portion (64) of the carrier strip (60) between the contact (18) and the next contact (18) to be inserted into the housing (10);
(c) indexing the housing (10) so that said next contact (18) to be inserted therein is adjacent an empty slot in said housing (10); and
(d) repeating the steps (b) and (c).

2. A method as claimed in claim 1, for inserting a chip carrier contact (18) into a housing (10), wherein the feeder ring (72) and the cutter ring (74) are disposed on the feeder/cutter (66).

## Patentansprüche

1. Verfahren zum Einsetzen eines Chipträgerkontakts (18) in ein Gehäuse (10) mit den Schritten:
(a) Anordnen eines Trägerstreifens (60), der Kontakte (18) und eine Indexierkerbe (58) hat, die einheitlich mit dem Trägerstreifen (60) ausgebildet sind, benachbart zu einem Chipträgergehäuse und zu einer Zuführ- und Schneidvorrichtung (66);
(b) kontinuierliches Drehen der Zuführ- und Schneidvorrichtung (66), so daß ein spiralförmig angeordneter Zuführring (72) an der Indexierkerbe (58) angreift und dadurch den Kontakt (18) in Schlitze drückt, die in dem Gehäuse (10) enthalten sind. während ein nockenartiger Schneidring (74) den einzusetzenden Kontakt (18) von dem Trägerstreifen wie auch einen Abschnitt (64) des Trägerstreifens (60) zwischen dem Kontakt (18) und dem nächsten in das Gehäuse (10) einzusetzenden Kontakt (18) abtrennt;
(c) Indexieren des Gehäuses (10), so daß der nächste darin einzusetzende Kontakt (18) benachbart zu einem leeren Schlitz in dem Gehäuse (10) ist; und
(d) Wiederholen der Schritte (b) und (c).

2. Verfahren nach Anspruch 1, zum Einsetzen eines Chipträgerkontakts (18) in ein Gehäuse (10), wobei der Zuführring (72) und der Schneidring (74) an der Zuführ- und Schneidvorrichtung (66) angeordnet sind.

## Revendications

1. Procédé pour introduire un contact (18) de support de puce dans un socle (10), comprenant les étapes qui consistent :
(a) à positionner une bande (60) de support ayant des contacts (18) et une encoche (58) d'indexage formés d'une seule pièce avec la bande (60) de support, à proximité immédiate d'un socle de support de puce et d'un dispositif (66) d'avancement/sectionnement ;
(b) à faire tourner en continu le dispositif (66) d'avancement/sectionnement afin qu'un anneau (72) d'avancement disposé en spirale attaque l'encoche (58) d'indexage pour enfoncer ainsi les contacts (18) dans des fentes situées dans le socle (10), tandis qu'un couteau annulaire (74) analogue à une came sectionne le contact (18), pendant qu'il est introduit, de la bande (60) de support ainsi qu'une partie (64) de la bande (60) de support entre le contact (18) et le contact suivant (18) devant être introduit dans le socle (10)
(c) à indexer le socle (10) afin que ledit contact suivant (18) devant être introduit dans celui-ci soit adjacent à une fente vide dans ledit socle (10) ; et
(d) à répéter les étapes (b) et (c).

2. Procédé selon la revendication 1, pour introduire un contact (18) de support de puce dans un socle (10), dans lequel l'anneau (72) d'avancement et le couteau annulaire (74) sont disposés sur le dispositif d'avancement/sectionnement (66).
